# EUROPEAN PATENT SPECIFICATION

(11) **EP 0 868 783 B1**
(45) Date of publication and mention of the grant of the patent: **29.08.2001**
(21) Application number: 96934618.8
(22) Date of filing: 10.10.1996
(51) Int. Cl.: H03L 7/14

(54) **PROCEDURE AND CIRCUIT FOR HOLDING LOCK STATE IN A DIGITAL PLL**
VERFAHREN UND SCHALTUNG ZUR AUFRECHTERHALTUNG DES SYNCHRONISIERTEN ZUSTANDES IN EINEM DIGITALEN PHASENREGELKREIS
PROCEDE ET CIRCUIT POUR MAINTENIR UN ETAT DE VERROUILLAGE DANS UNE LIAISON A VERROUILLAGE DE PHASE NUMERIQUE

(30) Priority: 20.12.1995 IT MI952679
(43) Date of publication of application: 07.10.1998
(73) Proprietor: Siemens Information and Communication Networks S.p.A., 20126 Milano (IT)
(72) Inventor: VITI, Maurizio, I-20048 Carate Brianza (IT)
(74) Representative: Giustini, Delio
(86) International application number: EP9604405
(87) International publication number: WO9723049

(56) References cited:
- EP-A- 0 115 326
- EP-A- 0 479 237
- DE-A- 2 456 742
- PATENT ABSTRACTS OF JAPAN vol. 006, no. 238 (E-144), 26 November 1982 & JP,A,57 140034 (NIPPON DENKI KK), 30 August 1982,

## Description

The present invention relates to the field of generation of clock signals for the timing of digital equipment and specifically to a procedure for lock holding in a digital PLL during any transient breaks in the synchronized signal.

As known, the use of a phase lock link (PLL) as a local clock signal generator gives the generator the ability to follow a synchronized - or reference - signal until it achieves the lock at the exact frequency of the reference signal.

This is a doubtless advantage in complex digital equipment consisting of several modules because it allows distributing a single synchronizing frequency which is a sub-multiple of that of the locally generated clock to each individual module to eliminate the problems of immunity to noise otherwise connected with the distribution of a very high frequency such as is normally that of the main clock.

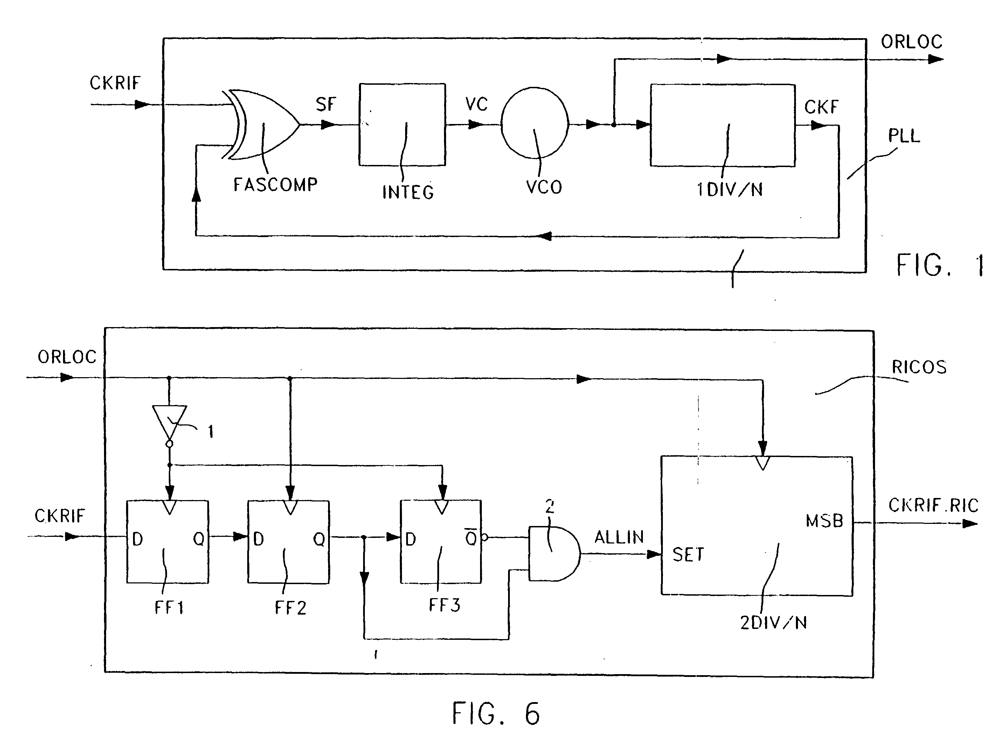

The standard diagram of a digital PLL can be seen in FIG. 1. With reference to this FIG. there is seen a block PLL (representing the PLL by coincidence of names) to whose input arrives from the exterior a digital reference signal CKRIF having frequency fᵣ and at whose output is generated a digital clock signal ORLOC having frequency f_{c} = Nfᵣ. The block PLL comprises a voltage-controlled oscillator VCO which generates the signal ORLOC and sends it to a divider by N indicated by 1DIV/N. The latter produces at output a comparison signal CKF having frequency f_{c}/N which is fed back to an input of a phase comparator FASCOMP implemented by means of a logical gate of the OR-EXCLUSIVE type to whose other input arrives the reference signal CKRIF. The output of FASCOMP is connected to the input of an integrator circuit INTEG whose output is connected to the control input of the VCO.

In operation it can be seen that, with the exception of the block INTEG, all the other blocks produce at output digital signals. For example, the phase comparator FASCOMP produces a square wave whose full:empty ratio supplies a measure of the phase displacement between the reference CKRIF and comparison CKF signals present at the inputs with the displacement being caused by the cumulative effect in time of the frequency difference thereof.

The fact that the synchronizing signal is digital does not constitute per se a limitation with respect to a possible analog synchronizing signal. Indeed, it is sufficient to use a level discriminator of known type to create from an analog synchronizing signal a corresponding two-level digital signal.

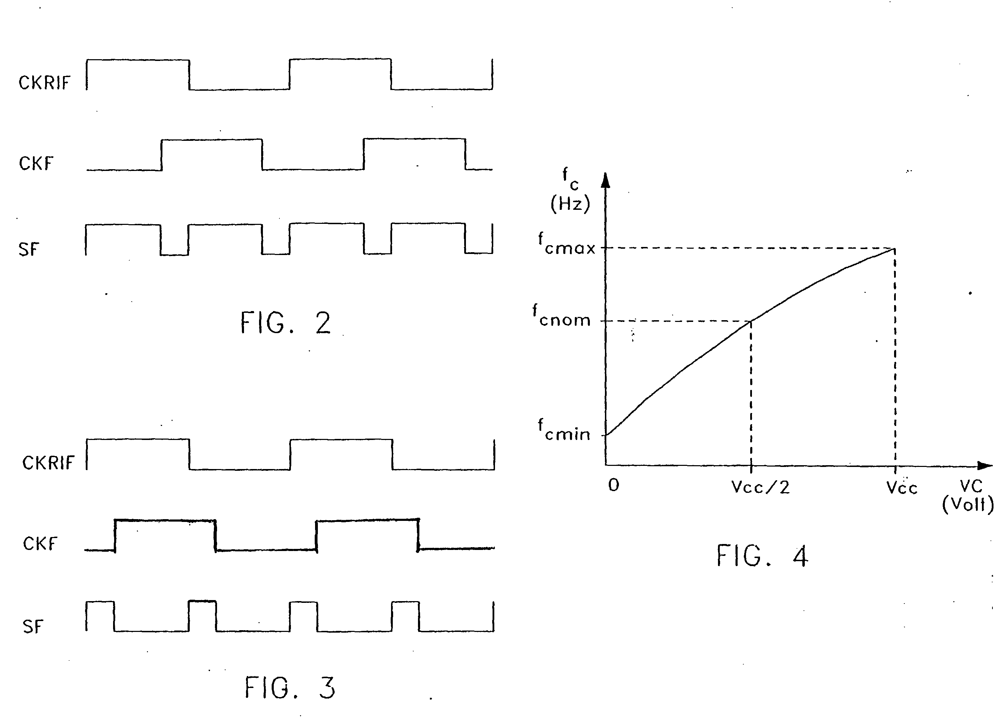

With reference to FIGS. 2 and 3 there is shown the behaviour in time of the signals CKRIF, CKF and SF for two different situations which occur respectively when the frequency f_{c}/N of the comparison signal CKF is slower than the signal fᵣ of the reference signal CKRIF and when it is faster. As may be seen, in the former case the signal SF is a square wave in which the full:empty ratio is greater than 50% while in the latter case it is less. Bu when f_{c}/N = fᵣ the frequency f_{c} takes on the nominal value f_{cnom} and thereat the full:empty ratio of SF becomes exactly 50%.

The integrator INTEG takes the continuous component of the signal SF constituting the control signal VC for correction of the frequency f_{c} of the signal ORLOC generated by the VCO. The frequency correction of the comparison signal CKF created by division takes place as a result.

In FIG. 4 is shown the behaviour of the frequency f_{c} as a function of the control voltage VC of the VCO in an ideal situation such that when the control voltage VC takes on a nominal value corresponding to one-half of the nominal supply voltage Vcc of the device VCO the frequency f_{c} takes on its nominal value f_{cnom}.

From the chart of FIG. 4 it may be seen that when the voltage VC is different from the ideal value Vcc/2, as e.g. during the transient for achievement of the lock or in the presence of microbreaks or slight displacements of frequency of the signal CKRIF, the VCO introduces variations in the frequency f_{c} of the clock signal ORLOC with respect to the nominal value f_{cnom} having a value and sign such that the phase difference between the two signals CKF and CKRIF at the input of the phase comparator FASCOMP is constantly brought back to π/2. Therewith the frequency difference between these signals is constantly canceled out.

In real cases the voltage VC corresponding to the nominal frequency f_{cnom} can shift considerably from the value Vcc/2 of FIG. 4 due to the effect of surrounding temperature which can vary from 0° C to 70° C in the range of operation and due to the effect of the supply voltage Vcc which can vary in a range. of validity of +10%. There is also the 'aging' phenomenon of the VCO which progressively takes the nominal voltage from the center of the characteristic to one of the two ends. Therefore the PLL of FIG. 1 is normally found operating with a lock voltage VC between 0 and Vcc, to which corresponds in any case the nominal frequency f_{c} included between a minimum frequency f_{cmin} and a maximum frequency f_{cmax}. In the real case indeed the difference in fixed phase between the two signals CKRIF and CKF at the input of the phase comparator FASCOMP will be other than π/2 but will be such that the wave form of the corresponding signal SF has a full:empty ratio which, once integrated, will supply a voltage VC always corresponding to the nominal frequency f_{cnom}.

There are many types of digital equipment which use PLL to regenerate the clock signal locally. Among these, those falling within the direct competence of the applicant and for which the invention was specifically developed are the public voice and data switching networks (PSTN) and public mobile telephone networks (PLMN). As known, these networks generally extend over large geographical areas and nevertheless all the equipment of the network must operate synchronously. To this end a single synchronizing frequency is distributed at the various points of the network and a synchronizing diagram is used in which each element of the network receives the synchronizing frequency for its own PLL from another element which has a higher hierarchical rank in the network. To make this diagram more flexible the more important elements of the network in some particular cases can also operate temporarily with their own PLL unlocked from the synchronizing frequency. This takes place e.g. when the source of the synchronizing frequency is missing because of failures or reconfigurations which occur in other parts of the network. In this case, before- the original synchronizing source is replaced with another source, these network elements utilize the high accuracy and stability of their oscillator to remain in a nearly synchronous or plesiochronous state with the rest of the network while waiting to resynchronize therewith.

This capability is not in general supplied to the minor elements of the network, for which being equipped with such an accurate oscillator as well as components and software necessary for managing it is too costly. Accordingly they must meet interruption of the synchronizing signal or other possible especially unfavorable operating conditions with only the capabilities offered by their own PLLs. If the latter are not capable of adequately meeting the above mentioned conditions there may occur malfunctions caused by loss of synchronization which in the less serious cases results only in loss of information and in the worst cases puts the individual network element out of order.

In the case of minor network elements using for synchronization the known PLL of FIG. 1 there can easily occur loss of lock in the presence of a temporary brief break - or microbreak - of the synchronization signal CKRIF. This shortcoming is due to the fact that the memory of the lock voltage at the nominal frequency is lost by the integrator INTEG during the microbreak. Specifically, in case of lack of the reference signal CKRIF the signal SF for input to the integrator INTEG instantly becomes the comparison signal CKF, straight or negated, depending on whether the signal CKRIF is broken in 0 state or 1 state. The integrator reacts to this instantaneous variation of the input voltage SF in the known manner, i.e. by varying its output voltage VC in a more or less impulsive manner before stabilizing at a value generally different from that which preceded the microbreak. When because of the new value of VC the frequency f_{c} is highly varied with respect to the previous value it is possible that upon reappearance of the synchronization signal CKRIF the PLL will lose the frequency lock. Beyond this conjecture, if the frequency f_{c} is slowed (or advanced) even by only 10 parts per million, i.e. 10 nanoseconds per millisecond, and if because of this delay (or advance) the phase displacement accumulated by the signal CKF during the microbreak exceeds +π/2, (or -π/2), the phase lock is lost at the front of CKRIF to which the PLL was locked previously. The above reasoning is based on the assumption normally occurring that at the end of the microbreak the signal CKRIF reappears without having undergone in the meantime a phase variation. As the phase displacement of the clock signal ORLOC usually takes place always in the same direction during different microbreaks, successive shifts do not compensate for each other and the cumulative effect produces a loss of data and voice by the system.

What was stated concerning the digital PLL of FIG. 1 applies also for digital PLLs with a phase comparator different from the EXCLUSIVE OR or which possess a phase-frequency comparator. To this last category belong the comparators capable of keeping the lock at the synchronizing front with phase 0 instead of with phase π/2 like that described above. In each of the above mentioned cases the memory of the lock voltage is lost in the absence of the synchronizer because no element of the link is capable of keeping indefinitely present any one magnitude defining the lock state.

In international patent application (PCT) no. WO 94/21048 in the name of NOKIA TELECOMMUNICATIONS with reference to the only FIG. 1, there is described a method for generation of a clock signal (CLK) by means of a phase lock link comprising a phase comparator (101), a link filter (102) and a voltage controlled oscillator (105) in which a synchronizing signal (MCLK) derived from a synchronism source is applied to a first input of the phase comparator (101) and the clock signal is locked to the synchronizing signal and characterized in that a sequence of samples of the oscillator control voltage (105) is memorized in a memory (111) for the entire duration of a predetermined time period in which the clock signal is locked to the synchronizing signal and that the sequence obtained from the memory replaces the control voltage obtained from the phase comparator (101) in response to a change in which a currently applied synchronizing signal becomes inadequate for its use in timing.

In the PLL which implements the circuitry of the above mentioned method there is inserted for the purpose a block for numerical processing (106) of the control voltage emerging from the link filter (102). This block (106), which comprises among other things a digital filter (107) of the low-pass type and a selector (110) is entirely implemented by means of a microprocessor timed by its own oscillator (112, 113). The digital filter (107) produces the above mentioned sequence of the control voltage which is memorized continually in an external memory (111) of the nonvolatile type. Under normal conditions of the synchronizing signal (MCLK) the selector (110) takes to the output of the processing block (106) the samples present at the output of the digital filter (107). But when the line interface circuits (114) signal to the microprocessor the presence of an alarm for the synchronizing signal (MCLK), the samples present in the external memory (111) are brought to the output of the processing block (106). In the link are of course inserted the necessary converters A/D and D/A.

From the foregoing the shortcomings of the quoted solution are obvious at first glance and consist essentially of being too costly, excessively complicating the circuit configuration of the PLL, necessitating a frequency reference signal (MCLK) equal to that of the clock (CLK) generated by the VCO, and lastly not enabling the PLL to remedy independently and automatically the microbreaks of the synchronizing signal but depending on alarm information generated outside it.

DE-A-2.456.742 discloses a PLL whose input reference, that must be used in the phase-frequency comparison, is obtained from an external synchronizing signal through a "logical filtering circuit" which is capable to compensate slow frequency changes, as well as momentary failures of this external signal, through comparing at first the relative position of the external signal with respect to an internal set of time marks, and taking then in any case the appropriate correction prevision by converting this set of references in the time domain into a set of logic functions which are capable of controlling the behaviour of the whole apparatus.

This circuit is therefore not applicable in interfacing a PCM bit stream to a PLL, because does not implement the clock reconstruction function, and its way of operation is not suitable to reach and to maintain the PLL lock condition in presence of microbreaks and jitter disturbances as specified by the ITU-T Recommendations for the PCM signal.

JP57140034 discloses a Phase Sinchronizing Oscillator to continuously output the preceding oscillation frequency even for a long time interruption of an external reference signal inputted to a terminal 13. The relevant embodiment in Figure comprises a PLL with inside a first counter/divider by m the frequency of the VCO, to obtain a first input signal for the phase comparator of the PLL whose reference input signal is provided from the output of a two way selector 20. A second counter/divider 17 external to the PLL divides by m the frequency of the VCO for providing a synthetic reference signal at one input of the selector 20. The second input of the selector 20 is connected at the output of a third counter 14 which divides by N the external reference signal at the terminal 13. When the last signal is interrupted, the interruption is detected by a circuit 15 which controls the selector 20 in order to switch over the output of the frequency divider 17 at the reference input of the phase comparator inside the PLL. The signal interruption detecting circuit 15 also controls a suppression circuit 19, whose task in presence of the external reference at the terminal 13 is that to synchronize the counting cycle of the two external counter/dividers 14 and 17.

Concerning the operation of the cited Japanese Phase Sinchronizing Oscillator we point out the following drawbacks:
a synchronizing mechanism which resets a counter (17) at each terminal counting of another counter (14) is intrinsically slow and unable to capture a front of the external clock at the input 13 (in particular a jittered one), and to sinchronize the synthetic reference in this circumstance. An aleatory phase error is consequent.

Divider 14 stops counting when its clock at the input 13 fails; the result is that, when the clock is resumed, the divided wave shape at the output of the divider 14 lies out of phase between -π and π with respect to the divided wave shape at the output of the divider 18. The result is a possible sudden large phase error at the reference input of the PLL at the reinstatement of the external reference after a microbreak.

From the above considerations we conclude that when the clock at the input 13 reappears from a microbreak at the reference input of the PLL, the PLL (if not already driven unlocked by the above sudden large phase error) could be most probably driven unlocked by the additional phase error due to the jitter of the reappeared clock.

A further drawback is imputable to the mechanism of selection of the synthetic reference signal at the PLL input in case of microbreaks, and vice versa; in fact, before an interruption be detected and the actual input of the selector 20 switched over, at least a pulse of the external reference signal goes lost. The phase error sudden increases consequently during the short time, after a microbreak, in which the reference input of the PLL remains without both the external and the synthesized reference signals. Being a short microbreak comparable to a string of PCM zeroes, we conclude that the proposed solution is yet not suitable for exploiting a PCM signal at the input 13, substantially because the mechanism of synchronization is unable to reconstruct the lacking front, or fronts.

Accordingly the purpose of the present invention is to overcome the above mentioned shortcomings and indicate a procedure for lock holding in a digital PLL during any transient breaks in the synchronizing signal.

To achieve the above mentioned purposes the present invention has for its subject matter a procedure for the generation of a local clock signal by means of a voltage controlled oscillator, or VCO, belonging to a digital phase lock link, or PLL, also comprising a first counter for frequency dividing by N the local clock and generating a comparison signal inputted to a first input of a phase comparator at whose second input arrives either an external digital synchronizing signal, possibly affected by either a jitter or temporary absence of level transitions, or a synthetic reference signal generated by a second counter frequency dividing by N the local clock externally to the PLL, and the phase comparator supplying a voltage variable in time whose quasi-continuous component extracted by an integrator commands the VCO to vary the frequency of the local clock signal in such a manner that the phase of the comparison signal and consequently that of the local clock signal are locked to the phase of the external synchronizing signal; besides the synthetic reference signal being phase aligned to the external synchronizing signal and replacing the latter in case of absence of level transitions, **characterized in that** it further comprises the following steps:
- sampling the external synchronizing signal with the pulses of the local clock signal generated by the VCO, for detecting either the trailing or leading edges, or fronts, of said external synchronizing signal;
- reinitializing the count of said second counter at each detection of said fronts;
- reconstructing a synchronizing signal for the second of said phase comparator inside the PLL, by accomplishing a logic OR between the synthetic reference signal and the externat synchronizing signal; the last, if being a PCM signal, its zeroes causing a voltage correspondent with a recognizable logic level.

The principal advantage of the procedure which is the subject matter of the present invention is to supply to the digital PLLs to which it is applied a memory of the lock state without the necessity of introducting even a minimal circuit modification thereof which, for the purposes of the procedure, can be seen as black boxes while utilizing for the purpose an added circuitry of small cost. Knowledge of the divider N used inside the PLL is easily inferred from the data sheet or directly obtainable from frequency measurements at the terminals.

The memory of the lock state as better explained below consists of a module counter N outside the PLL which is used to generate the reserve copy of the external synchronizing signal. The counter becomes such a memory starting from the instant following achievement of the phase lock between the signal emerging from the count and the external synchronizing signal. Indeed, while in the transient preceding the lock the PLL needs the external reference continuously, once the latter has been reached it becomes impossible to break the synchronizing signal provided it is promptly replaced by the signal emerging from the external counter. In this case the PLL would not lose the lock because the counter makes up for the lack of the external reference with a signal identical to the original before the break or, more precisely, which can differ in phase therefrom at most by ± 1/2 period of the local clock. As proof of this the dock signal generated by the PLL, since it does not undergo variations, continues to advance the count of the counter outside the PLL as though nothing had happened and the reserve synchronizing signal is consequently generated indefinitely with the same characteristics which the original had in the lock state just before the break.

From the foregoing it follows that thanks to the procedure which is the subject matter of the present invention there is introduced a substantial improvement in the stability and reliability of the local clock signals generated by using digital PLLs and they are less affected by jitter.

Another advantage of the procedure is that it is applied to PLLs in which the reference signal has a lower frequency that that of the locally generated clock, thus avoiding causing to circulate in the equipment too-high frequencies

Another advantage of the procedure is that it makes the PLL capable of remedying by itself and automatically the microbreaks of the synchronizing signal without thereby depending on alarm information generated externally thereto.

Another advantage of the procedure is lastly that, as better explained below, it allows the PLLs to generate a local clock signal using as an external synchronizing signal a temporal string of bits having the significance of data coming from a Pulse Code Modulation (PCM) signal.

Another subject matter of the present invention is a circuit for the generation of a clock signal implementing the above described procedure as set forth in claims 2 to 5.

The advantages of the procedure also extend by analogy to the circuit which, if employed in the minor elements of a telecommunications network, allows holding synchronism every where without making the systems presently in use more complicated and costly and there are also avoided the malfunctions connected with the losses of synchronization mentioned above.

Further purposes and advantages of the present invention are clarified in the detailed description of an embodiment thereof given below by way of nonlimiting example with reference to the annexed drawings wherein:
FIG. 1 shows a block diagram of a digital PLL in accordance with the prior art,
FIGS. 2 and 3 show wave forms of signals which concern the operation of a block FASCOMP of FIG. 1,
FIG. 4 shows a typical control function of a generic VCO,
FIG. 5 shows a block diagram of the circuit for the generation of a clock signal by means of a digital PLL with memorization of the lock point of the PLL which is the subject matter of the present invention,
FIG. 6 shows in greater detail a block RICOS of FIG. 5,
FIGS. 7 and 8 show wave forms of signals which time the operation of the principal blocks of FIGS. 5 and 6,
FIG. 9 shows a variant of the block diagram of FIG. 5,
FIG. 10 shows a PCM line connection applicable for the variation of FIG. 9, and
FIG. 11 shows the wave forms of input-output signals of a block RICOS' of FIG. 9.

As concerns the illustration of the PLL of FIG. 1 and the associated FIGS. 2, 3 and 4 reference is made to the remarks contained in the introduction.

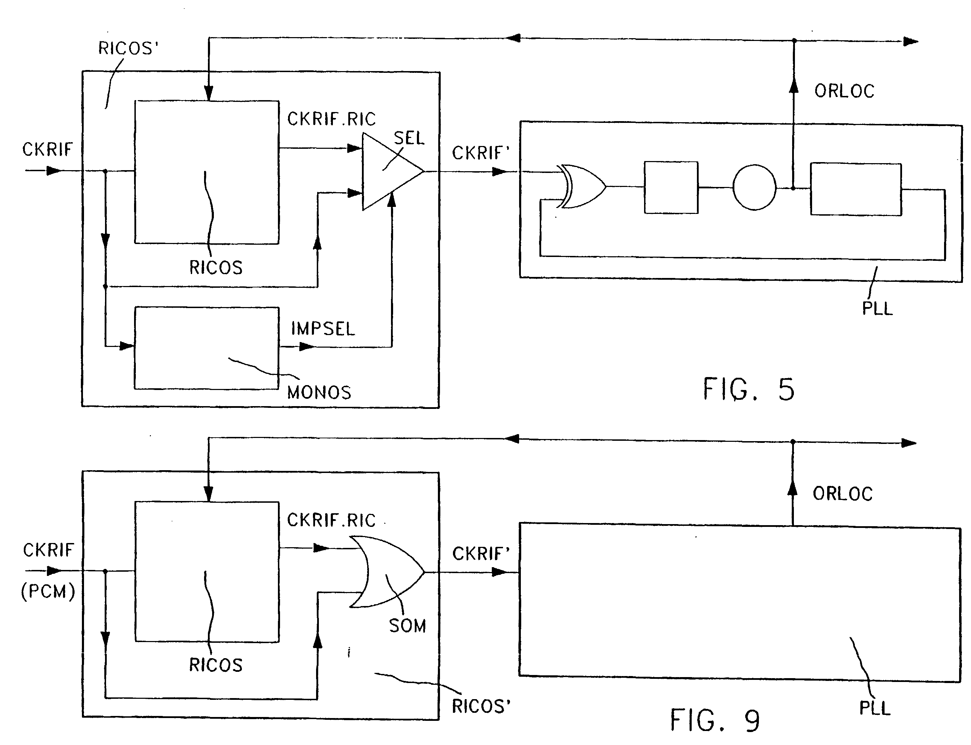

With reference to FIG. 5 there is noted a block RICOS' located upstream of a block PLL identical to that shown in FIG. 1. To a first input of the block RICOS' there arrives from the outside a synchronizing - or reference - digital signal CKRIF and to a second input a clock signal ORLOC generated by the block PLL. The signals ORLOC and CKRIF are identical to those of the same names of FIG. 1 but, as regards CKRIF, remarks set forth below are necessary. From the block RICOS' there emerges a synchronizing digital signal CKRIF' which reaches the input of the block PLL.

The block RICOS' includes a block RICOS for reconstruction of the synchronizing signal CKRIF, a monostable MONOS and a two-input selector SEL. The signals CKRIF and ORLOC reach the reconstruction block RICOS from which emerges a reconstructed synchronizing signal CKRIF.RIC directed to a first input of the selector SEL at whose second input arrives the original synchronizing signal CKRIF. At the selection input of SEL arrives a signal IMPSEL generated by the monostable MONOS operated by the signal CKRIF.

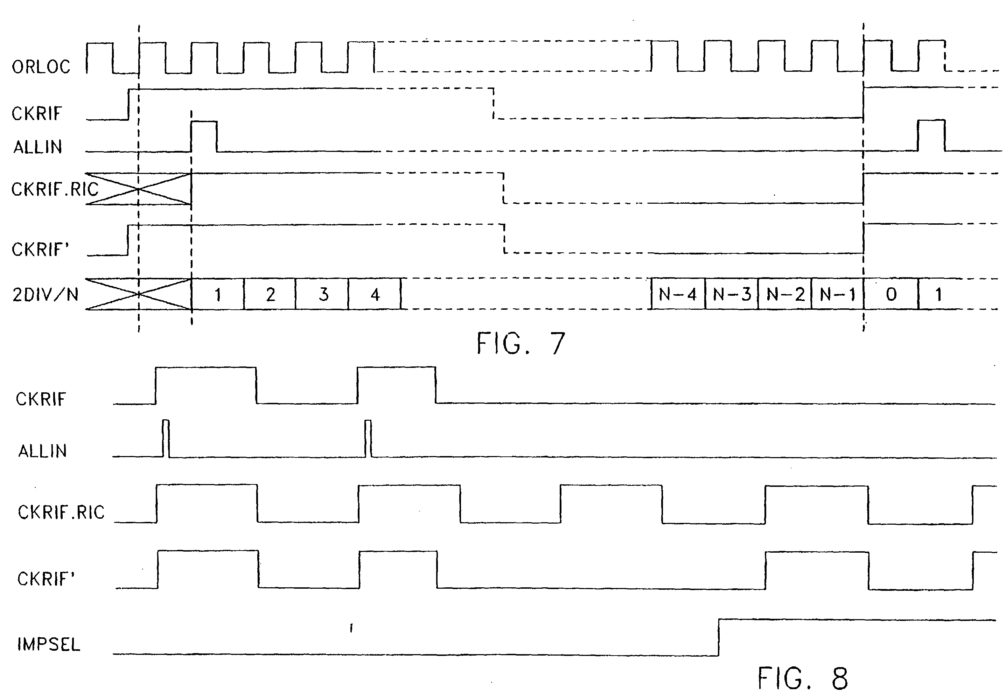

With reference to FIG. 6 in which the elements and signals common to the preceding FIGS. are indicated by the same symbols, it is seen that the block RICOS includes three type-D bistables indicated by FF1, FF2 and FF3 respectively and cascade connected together and with the signal CKRIF which reaches the input of the first thereof FF1. The clock signal ORLOC in true logical form reaches the clock input of the bistable FF2 and in negated form, obtained from a negater 1, the clock inputs of the bistables FF1 and FF3. The output of the last bistable FF3 is connected to a first input of a logical gate 2 having two type-AND inputs and whose other input is connected to the output of the bistable FF2. The output of the gate 2 is connected to the count start set input - or SET - of a module counter N indicated by 2DIV/N at whose dock input arrives the signal ORLOC. The signal emerging from an MSB pin of 2DIV/N corresponding to a most significant bit of the count is the reconstructed synchronizing signal CKRIF.RIC.

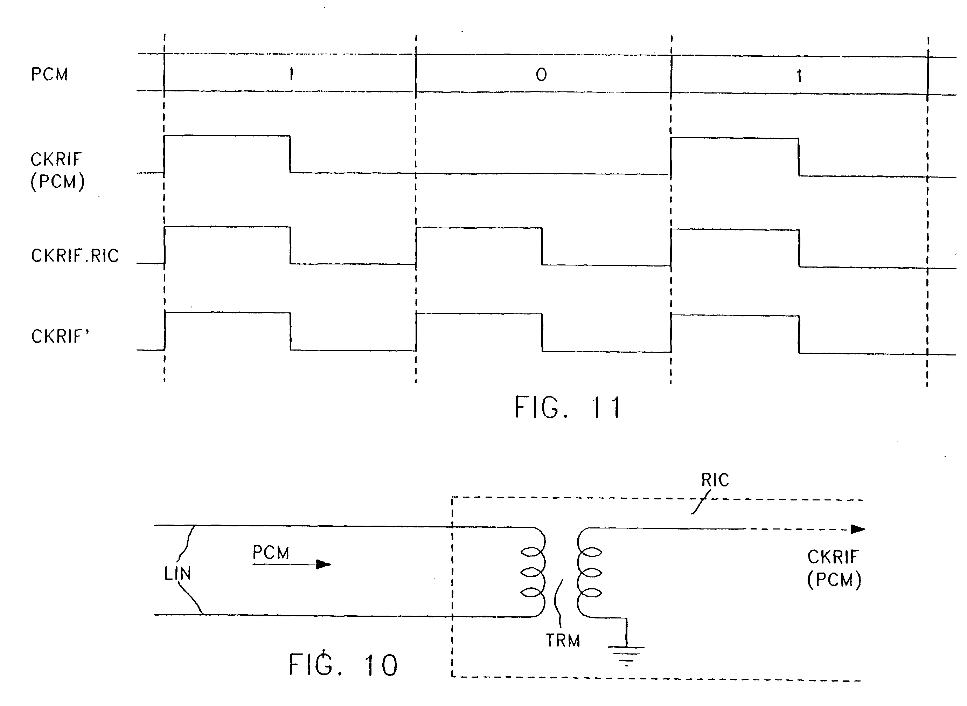

The operation of the circuits of FIGS. 5 and 6 is now discussed in the light of the above remarks concerning the procedure which is the subject matter of the present invention and with particular reference to the timings of FIGS. 7 and 8 of which FIG. 7 concerns the block RICOS and FIG. 8 concerns the blocks MONOS and SEL. From the procedure it follows that the counter 2DIV/N must be identical to the counter 1DIV/N in the PLL of FIG. 1 in such a manner that both divide the frequency of ORLOC by the same number N.

What appears evident immediately from a comparison of FIGS. 1 and 5 is that in the former case the synchronizing signal CKRIF reaches directly the input of the PLL while in the latter case it reaches it through the selector SEL which as an alternative can send to the PLL the synchronizing signal CKRIF.RIC reconstructed by the block RICOS. The two alternatives merge in the single signal CKRIF' which reaches the PLL. What determines the one choice or the other is the logical state of the signal IMPSEL generated by the monostable MONOS.

FIG. 8 shows that the signal CKRIF which under normal conditions corresponds to a square wave suddenly breaks and remains fixed at level zero. The monostable MONOS is used to detect the presence of the signal CKRIF. For this purpose, after each rising front of CKRIF the signal IMPSEL is held by the monostable at the low logical level for a certain time on duty equal to a few periods of CKRIF (1 in FIG. 8) during which the selector SEL allows the signal CKRIF to pass to the PLL. During a microbreak of the signal CKRIF lasting longer than the above mentioned duty time the signal IMPSEL switches to high logical level and to the output of the selector SEL is brought the signal CKRIF.RIC. The timing of the signal CKRIF' of FIG. 8 summarizes the remarks. The fact that between the break of CKRIF and restoration of CKRIF.RIC at the input of the PLL elapses the duty time during which the PLL is without any synchronizing signal does not involve significant drawbacks since the duty time is always chosen smaller than the time constant of the integrator INTEG (FIG. 1).

Summarizing the above discussion, the block RICOS' which implements the invention as circuitry always supplies at the input of the PLL a synchronizing signal CKRIF' even in the absence of the external synchronizing signal CKRIF. Specifically, the above mentioned block detects the presence of CKRIF and, if it finds it present, it does nothing but let it pass transparently to PLL while otherwise it synthesizes a synchronizing signal CKRIF.RIC which takes the place of the original. The reconstruction block RICOS completes the above mentioned operation by using the counter 2DIV/N to divide by N the frequency of the clock signal ORLOC generated by the PLL and the logic connected to the SET input of 2DIV/N to align the phase of the wave form corresponding to the states of the most significant bit MSB of the counter 2DIV/N with the phase of the reference signal CKRIF, an operation which it performs continuously during the presence of CKRIF. The wave form coming from MSB is taken in FIG. 7 in negated form but this does not affect the general nature of the mode of operation of the alignment logic.

As shown in FIG. 7, after each level transition of the signal CKRIF the circuit generates a pulse ALLIN which sets the content of the counter 2DIV/N to count value 1 during one period of the local clock ORLOC following that which starts in coincidence with the rising front of the signal CKRIF.RIC. In this manner the two signals CKRIF and CKRIF.RIC are aligned in phase within ± 1/2 period of ORLOC and indeed CKRIF is sampled by the bistable FF1 on the falling fronts of ORLOC while CKRIF RIC is generated on the rising fronts of ORLOC.

In the left-hand side of FIG. 7 is shown a situation in which the signal CKRIF is in advance of CKRIF.RIC but this does not affect the general nature of the above remarks on the behaviour of the circuit of FIG. 6 with respect to the case where the signal CKRIF is delayed with respect to CKRIF.RIC. In both cases the loop feedback of the PLL will ensure that after a certain number of count cycles of 2DIV/N the signal CKRIF.RIC will align in phase with CKRIF as shown in FIG. 7 on the right. Specifically, even when the PLL reaches lock while holding a phase displacement other than null between the reference CKRIF and the comparison signal CKF (FIG. 1) as in general takes place for the PLL of FIG. 1, the phase displacement between CKRIF and CKRIF.RIC always remains within ± 1/2 period of ORLOC.

With reference to FIG. 9 there is illustrated a circuitry variant applicable when the external synchronizing signal is a PCM line signal as indicated in FIG. 9 by CKRIF (PCM). The block diagram of FIG. 9 differs from that of FIG. 5 only in that one logic gate with two inputs SOM of type OR replaces the selector SEL and the monostable MONOS is also absent.

FIG. 10 shows a typical PCM line connection in which can be seen a transmission line LIN which enters a receiver RIC and is connected there to the primary of a pulse transformer TRM. The receiver RIC also comprises, even if not expressly indicated, the circuits of the of FIG. 9. The secondary of the transformer TRM has one end connected to the same ground to which are connected the circuitry devices of the receiver RIC. On the line LIN travels a PCM reception signal which is transferred to the secondary of TRM and thence reaches the input of the block RICOS and the logical gate SOM of the variant. Some bits of the PCM serial signal and the associated wave form CKRIF.RIC can be seen in the first two timings indicated above in FIG. 11 where it can be seen that the signal CKRIF (PCM) can be considered a clock signal with fronts missing opposite the bits having logical value zero.

As known, in accordance with certain hypotheses it is possible to utilize a PCM signal for the synchronization of a PLL because it is the PLL which reconstructs the fronts missing opposite the zeroes of the PCM data. The PCM line signal includes an appropriate code which remedies the cases where a long sequence of zeroes in the PCM data would make regeneration of the clock done with a PLL not having memory of the lock state critical.

The circuit variant of FIG. 9 allows for the fact that in the absence of the signal CKRIF (PCM) a low logic level is always caused at the input of the circuits of the receiver RIC (FIG. 10) because of the alternate coupling of the PCM signal and the grounding of one end of the secondary of the pulse transformer TRM. In this case it is therefore possible to select the synchronizing signal best suited to be sent to the PLL by means of a simple logical gate OR possessing also the advantage of adding to the signal CKRIF (PCM) all the fronts missing opposite the zeroes of the PCM datum.

A similar simplification would not be applicable to the blocks of FIG. 5 because in the absence of the signal CKRIF there would be uncertainty about the logical state at the input of the gate OR which would replace the selector SEL and the monostable MONOS.

In FIG. 11 can be seen the wave forms of the signals present at the input and output of the gate SOM of FIG. 9, from which it is noted that the reconstructed synchronizing signal CKRIF.RIC supplies to the signal CKRIF', entering the PLL, the fronts which are missing in the signal CKRIF (PCM) and replaces the latter when the latter breaks. From the above remarks it follows that since CKRIF' is now a clock signal not missing any front it can be divided inside the PLL so as to perform the phase comparison at a lower frequency than the line frequency which is 2048 kHz.

## Claims

1. Procedure for the generation of a local clock signal (ORLOC) by means of a voltage controlled oscillator, or VCO, belonging to a digital phase lcck link, or PLL, also comprising a first counter (1DIV/N) for frequency dividing by N the local clock and generating a comparison signal (CKF) inputted to a first input of a phase comparator (FASCOMP) at whose second input arrives either an external digital synchronizing signal (CKRIF), possibly affected by either jitter or temporary absence of level transitions, or a synthetic reference signal (CKRIF.RIC) generated by a second counter (2DIV/N) frequency dividing by N, externally to the PLL, the local clock signal (ORLOG), and the phase comparator (FASCOMP) supplying a voltage variable in time (SF) whose quasi-continuous component (VC) extracted by an integrator (INTEG) commands the VCO to vary the frequency of the local clock signal in such a manner that the phase of the comparison signal (CKF) and consequently that of the local clock signal (ORLOC) are locked to the phase of the external synchronizing signal (CKRIF); besides the synthetic reference signal being phase aligned to the external synchronizing signal and replacing the latter in case of absence of level transitions, **characterized in that** it further comprises the following steps:
- sampling the external synchronizing signal (CKRIF) with the pulses of the local clock signal (ORLOC) generated by the VCO, for detecting either the trailing or leading edges, or fronts, of said external synchronizing signal (CKRIF);
- reinitializing the count of said second counter (2DIV/N) at each detection of said fronts;
- reconstructing a further synchronizing signal (CKRIF') for the second input of said phase comparator (FASCOMP) inside the PLL, by accomplishing a logic OR between the synthetic reference signal (CKRIF.RIC) and the external synchronizing signal (CKRIF); the last, if being a PCM signal, is so coupled that in its absence a zero logic level is generated, allowing the synthetic reference signal (CKRIF.RIC) to take control of the PLL.

2. Procedure for the generation of a local clock signal (ORLOC) in accordance with claim 1, **characterized in that** the count of said second counter (2DIV/N) is reinitialized by a short pulse which duration is lower than one period of said local clock signal (ORLOC) generated by the VCO.

3. Circuit for the generation of a local clock signal (ORLOC) by means of a voltage controlled oscillator, or VCO, belonging to a digital phase lock link, or PLL, also comprising a first counter (1DIV/N) for frequency dividing by N the local clock and generating a comparison signal (CKF) inputted to a first input of a phase comparator (FASCOMP) at whose second input arrives either an external digital synchronizing signal (CKRIF), possibly affected by either jitter or temporary absence of level transitions, or a synthetic reference signal (CKRIF.RIC) generated by a second counter (2DIV/N) frequency dividing by N, extemally to the PLL, the local clock signal (ORLOG), and the phase comparator (FASCOMP) supplying a voltage variable in time (SF) whose quasi-continuous component (VC) extracted by an integrator (INTEG) commands the VCO to vary the frequency of the local clock signal in such a manner that the phase of the comparison signal (CKF) and consequently that of the local clock signal (ORLOC) are locked to the phase of the external synchronizing signal (CKRIF); the circuit comprising a syncrhronization circuit (RICOS') for phase aligning the synthetic reference signal to the external synchronizing signal and replacing the latter in case of absence of level transitions, **characterized in that** said synchronization circuit (RICOS') includes:
- sampling and reinitializing means (1, FF1, FF2, FF3, 2) for sampling the external synchronizing signal (CKRIF) by means. of pulses of said local clock (ORLOC) in order of detecting either the trailing or leading edges of said external signal, and for reinitializing the count of said second counter (2DIV/N) at each detection of said edges, or fronts;
- means for reconstructing (SOM) a further synchronizing signal (CKRIF') for the second input of said phase comparator (FASCOMP) inside the PLL, by accomplishing a logic OR between the synthetic reference signal (CKRIF.RIC) and the external synchronizing signal (CKRIF); the last, if being a PCM signal, is so coupled that in its absence a zero logic level is generated, allowing the sinthetic reference signal (CKRIF.RIC) to take control of the PLL.

4. Circuit for the generation of a local clock signal (ORLOC) in accordance with claim 3, **characterized in that** said sampling and reinitializing means (1, FF1, FF2, FF3, 2) is for generating a short reinitializing pulse (ALLIN) whose duration is lower than one period of said local clock signal (ORLOC) generated by the VCO.

5. Circuit for the generation of a local clock signal (ORLOC) in accordance with claim 3 or 4, **characterized in that** said sampling and reinitializing means (1, FF1, FF2, FF3, 2) consists of three type-D bistables located in cascade (FF1,FF2,FF3) of which a first (FF1) at which arrives said external synchronizing signal (CKRIF) and a third (FF3) whose output is connected to a starting count pin (SET) of said second counter (2/DIVN) are timed by the falling fronts of said local clock signal (ORLOC), while the remaining bistable (FF2) which is located between the two above is timed by the rising fronts of this signal.

6. Circuit for the generation of a local clock signal in accordance with claim 5, **characterized in that** the negated output of said third bistable (FF3) is connected to said starting count pin (SET) through a logical gate with two inputs (2) of the AND type whose second input is connected to the input of the third bistable (FF3).

7. Circuit for the generation of a local clock signal in accordance with any of claims 3 through 6, **characterized in that**, due to the loop feedback effect of the PLL, said sampling and reinitializing means (1, FF1, FF2, FF3, 2), said means (SOM) for reconstructing a synchronizing signal (CKRIF'), said second counter (2/DIVN), generating a synthesized reference signal (CKRIF.RIC), reproduced in negated form at an output corresponding to a most significant bit (MSB) of said second counter (2/DIVN), which is locked in frequency and phase with the external synchronizing signal (CKRIF) while differing in phase therewith at most by ± 1/2 period of the local clock signal (ORLOC).

## Patentansprüche

1. Ein Verfahren für die Generierung eines lokalen Taktsignals durch einen spannungsgesteuerten Oszillator (VCO) innerhalb eines digitalen Phasenregelkreises (PLL), der einen ersten Zähler (1DIV/N) für die Frequenzteilung des lokalen Takts durch N enthält und ein Vergleichssignal (CKF) generiert, das auf den ersten Eingang eines Phasenkomparators (FASCOMP) gelegt wird. An den zweiten Eingang wird entweder ein externes digitales Synchronisierungssignal, bei dem entweder Jitter oder kurzzeitige Aussetzer der Pegelübergänge auftreten können, oder ein künstliches Referenzsignal (CKRIF.RIC) angelegt, das von einem zweiten Zähler (2DIV/N, außerhalb des PLL untergebracht) durch Teilen der Frequenz durch N generiert wird. Weiterhin gehören ein externer lokaler Takt (ORLOC) und der Phasenkomparator (FASCOMP) dazu. Letzterer liefert eine über die Zeit variable Spannung (SF), deren von einem Integrator (INTEG) gelieferte Quasi-Gleichspannungskomponente (VC) den VCO so ansteuert, dass die Frequenz des lokalen Taktsignals so verändert wird, dass die Phase des Vergleichssignals und damit die Phase des lokalen Taktsignals mit der Phase des externen Synchronisierungssignals synchronisiert werden. Zudem wird die Phase des künstlichen Referenzsignals mit der des externen Synchronisierungssignals synchronisiert und letzteres bei nicht vorhandenen Pegelübergängen ersetzt. Der Gegenstand der Erfindung **umfasst weiterhin** folgende Bestandteile:
- Abtastung des externen Synchronisierungssignals (CKRIF) mit den Impulsen des vom VCO generierten lokalen Taktsignals (ORLOC) zur Erkennung der hinteren bzw. vorderen Flanken des externen Synchronisierungssignals (CKRIF)
- Reinitialisierung des zweiten Zählers (2DIV/N) bei jeder Erkennung der vorgenannten Flanken
- Rekonstruktion eines weiteren Synchronisierungssignals (CKRIF') für den zweiten Eingang des Phasenkomparators (FASCOMP) innerhalb des PLLs durch ein logisches OR-Glied zwischen dem künstlichen Referenzsignal (CKRIF.RIC) und dem externen Synchronisierungssignal (CKRIF). Wenn es sich bei letzterem um ein PCM-Signal handelt, wird dieses so angekoppelt, dass bei Ausbleiben des Signals ein logischer Null-Pegel erzeugt und der PLL von dem künstlichen Referenzsignal (CKRIF.RIC) angesteuert wird.

2. Ein Verfahren zur Erzeugung eines lokalen Taktsignals (ORLOC) entsprechend Patentanspruch 1, bei dem der Zählerstand des besagten zweiten Zählers (2DIV/N) durch einen kurzen Impuls neu initialisiert wird, dessen Dauer kürzer als eine Periode des vom VCO erzeugten besagten lokalen Taktsignals (ORLOC) ist.

3. Ein Schaltkreis für die Generierung eines lokalen Taktsignals (ORLOC) durch einen spannungsgesteuerten Oszillator (VCO) innerhalb eines digitalen Phasenregelkreises (PLL), der einen ersten Zähler (1DIV/N) für die Frequenzteilung des lokalen Takts durch N enthält und ein Vergleichssignal (CKF) generiert, das auf den ersten Eingang eines Phasenkomparators (FASCOMP) gelegt wird. An den zweiten Eingang wird entweder ein externes digitales Synchronisierungssignal, bei dem Jitter oder kurzzeitige Aussetzer der Pegelübergänge auftreten können, oder ein künstliches Referenzsignal (CKRIF.RIC) angelegt, das von einem zweiten Zähler (2DIV/N, außerhalb des PLL untergebracht) durch Teilen der Frequenz durch N generiert wird. Weiterhin gehören ein externer lokaler Takt (ORLOC) und der Phasenkomparator (FASCOMP) dazu. Letzterer liefert eine über die Zeit variable Spannung (SF), deren von einem Integrator (INTEG) gelieferte Quasi-Gleichspannungskomponente (VC) den VCO so ansteuert, dass die Frequenz des lokalen Taktsignals so verändert wird, dass die Phase des Vergleichssignals und damit die Phase des lokalen Taktsignals mit der Phase des externen Synchronisierungssignals (CKRIF) synchronisiert wird. Zudem wird die Phase des künstlichen Referenzsignals durch die Synchronisierungsschaltung (RICOS') mit der Phase des externen Synchronisierungssignals synchronisiert und letzteres bei nicht vorhandenen Pegelübergängen ersetzt. Die besagte Synchronisierungsschaltung (RICOS') umfasst weiterhin folgende Bestandteile:
- Komponenten zur Abtastung und Reinitialisierung (1, FF1, FF2, FF3, 2) zur Abtastung des externen Synchronisierungssignals (CKRIF) mit den Impulsen des lokalen Taktsignals (ORLOC) zur Erkennung der hinteren bzw. vorderen Flanken des externen Synchronisierungssignals (CKRIF) und zur Reinitialisierung des Zählerstands des zweiten Zählers (2DIV/N), sobald die besagten Flanken erkannt werden
- Komponenten zur Rekonstruktion (SOM) eines weiteren Synchronisierungssignals (CKRIF') für den zweiten Eingang des Phasenkomparators (FASCOMP) innerhalb des PLLs durch ein logisches OR-Glied zwischen dem künstlichen Referenzsignal (CKRIF.RIC) und dem externen Synchronisierungssignal (CKRlF). Wenn es sich bei letzterem um ein PCM-Signal handelt, wird dieses so angekoppelt, dass bei Ausbleiben des Signals ein logischer Null-Pegel erzeugt und der PLL von dem künstlichen Referenzsignal (CKRIF.RIC) angesteuert wird.

4. Eine Schaltung zur Erzeugung eines lokalen Taktsignals (ORLOC) entsprechend Patentanspruch 3, bei dem die besagten Komponenten zur Abtastung und Reinitialisierung (1, FF1, FF2, FF3, 2) einen kurzen Reinitialisierungsimpuls (ALLIN) erzeugen, dessen Dauer kürzer als eine Periode des vom VCO erzeugten lokalen Taktsignals (ORLOC) ist.

5. Eine Schaltung zur Erzeugung eines lokalen Taktsignals (ORLOC) entsprechend Patentanspruch 3 oder 4, bei dem die besagten Komponenten zur Abtastung und Reinitialisierung (1, FF1, FF2, FF3, 2) aus drei hintereinandergeschalteten D-Flip-Flops (FF1,FF2,FF3) bestehen. Dabei wird das externe Synchronisierungssignal (CKRIF) an den ersten Flip-Flop (FF1) und der Ausgang des dritten Flip-Flops (FF3) an den Anschluss für den Beginn der Zählung (SET) des zweiten Zählers (2DIV/N) angeschlossen. Der erste und der dritte Flip-Flop werden bei fallender Flanke und der verbleibende zweite Flip-Flop (FF2) zwischen diesen beiden Flip-Flops bei steigender Flanke des lokalen Taktsignals (ORLOC) weitergeschaltet.

6. Eine Schaltung zur Erzeugung eines lokalen Taktsignals entsprechend Patentanspruch 5, bei der der negierte Ausgang des dritten Flip-Flops (FF3) über ein logisches Gatter (AND-Glied) mit zwei Eingängen (2) (der zweite Eingang ist mit dem Eingang des dritten Flip-Flops (FF3) verbunden) an den besagten Anschluss für den Beginn der Zählung (SET) angeschlossen ist.

7. Eine Schaltung zur Erzeugung eines lokalen Taktsignals entsprechend den Patentansprüchen 3 bis 6, bei dem die besagten Komponenten zur Abtastung und Reinitialisierung (1, FF1, FF2, FF3, 2), die Komponenten (SOM) zur Rekonstruktion eines Synchronisierungssignals (CKRIF') und der zweite Zähler (2DIV/N) unter Ausnutzung des Schleifenrückführungseffekts des PLL ein künstliches Referenzsignal (CKRIF.RIC) erzeugen, das am Ausgang des höchstwertigsten Bits (MSB) des besagten zweiten Zählers (2DIV/N) in negierter Form reproduziert wird, wobei Frequenz und Phase mit dem externen Synchronisierungssignal (CKRIF) übereinstimmen und die Phase höchstens um ± 1/2 Periode vom lokalen Taktsignal (ORLOC) abweicht.

## Revendications

1. Procédé de production d'un signal d'horloge locale (ORLOC) au moyen d'un oscillateur commandé en tension, ou VCO, faisant partie d'une liaison à verrouillage de phase numérique, ou PLL, comprenant aussi un premier compteur (1DIV/N) pour diviser par N la fréquence du signal d'horloge locale et produire un signal de comparaison (CKF) introduit à une première entrée d'un comparateur de phases (FASCOMP) à la seconde entrée duquel arrive ou bien un signal de synchronisation numérique externe (CKRIF), peut-être affecté soit par une gigue, soit par une absence temporaire de transitions de niveau, ou bien un signal de référence synthétique (CKRIF.RIC) produit par un second compteur (2DIV/N) divisant par N, à l'extérieur de la PLL, la fréquence du signal d'horloge locale (ORLOG), et le comparateur de phases (FASCOMP) fournissant une tension variable dans le temps (SF) dont la composante quasi continue (VC) extraite par un intégrateur (INTEG) commande au VCO de varier la fréquence du signal d'horloge locale de telle manière que la phase du signal de comparaison (CKF) et par conséquent, celle du signal d'horloge locale (ORLOC) soient verrouillées à la phase du signal de synchronisation externe (CKRIF) ; le signal de référence synthétique étant en outre aligné en phase sur le signal de synchronisation externe et remplaçant ce dernier en cas d'absence de transitions de niveau, **caractérisé en ce qu**'il comprend par ailleurs les étapes suivantes:
- échantillonner le signal de synchronisation externe (CKRIF) avec les impulsions du signal d'horloge locale (ORLOC) produit par le VCO, pour détecter soit les flancs arrière soit les flancs avant, ou fronts, dudit signal de synchronisation externe;
- remettre à zéro le compte dudit second compteur (2DIV/N) à chaque détection desdits fronts ;
- reconstituer un signal de synchronisation (CKRIF') pour la seconde entrée dudit comparateur de phases (FASCOMP) agencé à l'intérieur de la PLL, en exécutant un OU logique entre le signal de référence synthétique (CKRIF.RIC) et le signal de synchronisation externe (CKRIF); ce dernier, si c'est un signal MIC, est couplé de telle sorte qu'en son absence, un niveau logique zéro est produit, ce qui permet au signal de référence synthétique (CKRIF.RIC) de prendre le contrôle de la PLL.

2. Procédé de production d'un signal d'horloge locale (ORLOC) selon la revendication 1, **caractérisé en ce que** le compte dudit second compteur (2DIV/N) est remis à zéro par une impulsion courte dont la durée est inférieure à une période dudit signal d'horloge locale (ORLOC) produit par le VCO.

3. Circuit de production d'un signal d'horloge locale (ORLOC) au moyen d'un oscillateur commandé en tension, ou VCO, faisant partie d'une liaison à verrouillage de phase numérique, ou PLL, comprenant également un premier compteur (1 DIVIN) pour diviser par N la fréquence du signal d'horloge locale et produire un signal de comparaison (CKF) introduit à une première entrée d'un comparateur de phases (FASCOMP) à la seconde entrée duquel arrive ou bien un signal de synchronisation numérique externe (CKRIF), peut-être affecté soit par une gigue, soit par une absence temporaire de transitions de niveau, ou bien un signal de référence synthétique (CKRIF.RIC) produit par un second compteur (2DIV/N) divisant par N, à l'extérieur de la PLL, la fréquence du signal d'horloge locale (ORLOG), et le comparateur de phases (FASCOMP) fournissant une tension variable dans le temps (SF) dont la composante quasi continue (VC) extraite par un intégrateur (INTEG) commande au VCO de varier la fréquence du signal d'horloge locale de telle manière que la phase du signal de comparaison (CKF) et par conséquent, celle du signal d'horloge locale (ORLOC) sont verrouillées à la phase du signal de synchronisation externe CKRIF) ; le circuit comprenant un circuit de synchronisation (RICOS') pour aligner en phase le signal de référence synthétique sur le signal de synchronisation externe et remplacer ce dernier en cas d'absence de transitions de niveau, **caractérisé en ce que** ledit circuit de synchronisation (RICOS') comprend:
- un moyen d'échantillonnage et de remise à zéro (1, FF1, FF2, FF3, 2) pour échantillonner le signal de synchronisation externe (CKRIF) au moyen d'impulsions de ladite horloge locale (ORLOC) afin de détecter soit les flancs arrière, soit les flancs avant dudit signal externe, et pour remettre à zéro le compte dudit second compteur (2DIV/N) à chaque détection desdits flancs, ou fronts ;
- un moyen pour reconstituer (SOM) un signal de synchronisation supplémentaire (CKRIF') pour la seconde entrée dudit comparateur de phases (FASCOMP) agencé à l'intérieur de la PLL, en exécutant un OU logique entre le signal de référence synthétique (CKRIF.RIC) et le signal de synchronisation externe (CKRIF); ce dernier, si c'est un signal MIC, est couplé de telle sorte qu'en son absence, un niveau logique zéro est produit, permettant au signal de référence synthétique (CKRIF.RIC) de prendre le contrôle de la PLL.

4. Circuit de production d'un signal d'horloge locale (ORLOC) selon la revendication 3, **caractérisé en ce que** ledit moyen d'échantillonnage et de remise à zéro (1, FF1, FF2, FF3, 2) sert à produire une impulsion courte de remise à zéro (ALLIN) dont la durée est inférieure à une période dudit signal d'horloge locale (ORLOC) produit par le VCO.

5. Circuit de production d'un signal d'horloge locale (ORLOC) selon la revendication 3 ou 4, **caractérisé en ce que** ledit moyen d'échantillonnage et de remise à zéro (1, FF1, FF2, FF3, 2) se compose de trois bistables du type D montés en cascade (FF1, FF2, FF3) dont un premier (FF1) auquel arrive ledit signal de synchronisation externe (CKRIF) et un troisième (FF3) dont la sortie est connectée à une broche de démarrage du compte (SET) dudit second compteur (2/DIVN) sont synchronisées par les fronts descendants dudit signal d'horloge locale (ORLOC), tandis que le bistable restant (FF2) qui est situé entre les deux ci-dessus est synchronisé par les fronts montants de ce signal.

6. Circuit de production d'un signal d'horloge locale selon la revendication 5, **caractérisé en ce que** la sortie inversée dudit troisième bistable (FF3) est connectée à ladite broche de démarrage du compte (SET) par l'intermédiaire d'une porte logique à deux entrées (2) du type ET dont la seconde entrée est connectée à l'entrée du troisième bistable (FF3).

7. Circuit de production d'un signal d'horloge locale selon l'une quelconque des revendications 3 à 6, **caractérisé en ce que**, en raison de l'effet de rétroaction en boucle de la PLL, ledit moyen d'échantillonnage et de remise à zéro (1, FF1, FF2, FF3, 2), ledit moyen (SOM) de reconstitution d'un signal de synchronisation (CKRIF'), ledit second compteur (2/DIVN), produisant un signal de référence synthétique (CKRIF.RIC), reproduit sous une forme inversée à une sortie correspondant à un bit le plus significatif (MSB) dudit second compteur (2/DIVN), qui est verrouillé en fréquence et en phase au signal de synchronisation externe (CKRIF) tout en différant de celui-ci en phase tout au plus de ± 1/2 période du signal d'horloge locale (ORLOC).
